**Europäisches Patentamt**

**European Patent Office**

**Office européen des brevets**

(19)

(11) Numéro de publication: **0 083 537**
**B1**

(12) # FASCICULE DE BREVET EUROPÉEN

(45) Date de publication du fascicule du brevet:
**12.03.86**

(51) Int. Cl.⁴: **H 01 G 13/00,** H 05 K 13/00

(21) Numéro de dépôt: **82402373.3**

(22) Date de dépôt: **23.12.82**

(54) Procédé et dispositif pour la mise en boîtier de composants électroniques.

(30) Priorité: **31.12.81 FR 8124586**

(43) Date de publication de la demande:
**13.07.83 Bulletin 83/28**

(45) Mention de la délivrance du brevet:
**12.03.86 Bulletin 86/11**

(84) Etats contractants désignés:
**DE GB NL**

(56) Documents cités:
**FR - A - 842 377**
**GB - A - 833 229**
**US - A - 4 268 942**

(73) Titulaire: **L.C.C.-C.I.C.E. - COMPAGNIE EUROPEENNE DE COMPOSANTS ELECTRONIQUES, 50, rue Jean-Pierre Timbaud B.P. 301, F-92402 Courbevoie (FR)**

(72) Inventeur: **Anne, Jean, THOMSON-CSF SCPI 173, bld Haussmann, F-75379 Paris Cedex 08 (FR)**

(74) Mandataire: **Ruellan-Lemonnier, Brigitte et al, THOMSON-CSF SCPI 173, boulevard Haussmann, F-75379 Paris Cedex 08 (FR)**

## Description

La presente invention concerne un dispositif pour la mise en boîtier de composants électroniques sur bande comportant des moyens d'avance pas à pas d'une bande sur laquelle sont disposées les connexions électriques des composants placés à une extrémité de celle-ci, des moyens d'avance pas à pas d'un support mobile portant des boîtiers, ainsi que des moyens de translation du composant sur la bande de manière à amener ledit composant dans un des boîtiers. Un dispositif de ce type est décrit par exemple dans le brevet américain 4 268 942.

L'invention concerne également un procédé de mise en boîtier de composants électroniques.

Dans le domaine des condensateurs, auquel se rapporte plus particulièrement l'invention, on réalise généralement des composants vendus sans boîtier d'encapsulation. Ces condensateurs possèdent en effet une résistance mécanique suffisante pour assurer leur protection. Toutefois, certains condensateurs de petites tailles ou particulièrement fragiles tels que les condensateurs en film plastique métallisé réalisés par empilement successif de films métallisés nécessitent une protection extérieure afin d'améliorer leur résistance aux chocs et leur donner un meilleur aspect extérieur. Généralement, la mise en boîtier des composants électroniques du type condensateurs consiste à introduire le composant dans un boîtier rempli de résine liquide durcissable. Le boîtier et son composant sont soutenus par un support jusqu'au durcissement de la résine qui permet alors de manipuler l'ensemble par les pattes de connexions du composant.

Pour effectuer cette opération de mise en boîtier, on positionne généralement ledit boîtier avec sa face ouverte disposée vers le haut puis on translate verticalement le composant dans le boîtier, parallèlement à ses pattes de connexions. Cette translation s'effectuant par l'intermédiaire desdites pattes de connexions, il est absolument impératif que celles-ci soient parfaitement rectilignes pour que l'opération d'introduction ait lieu dans de bonnes conditions. Or, bien souvent, ces connexions ne possèdent pas ce caractère rectiligne, et l'introduction s'effectue mal ou pas du tout ce qui donne un nombre de déchets assez important dans la chaîne de fabrication.

Le dispositif selon l'invention permet d'éviter ces inconvénients. Dans ce but, il est caractérisé en ce qu'il comporte en outre une pince constituée de deux mors qui, au contact l'un de l'autre, possèdent une empreinte intérieure qui a sensiblement la dimension extérieur du boîtier, le dit boîtier possèdant au moins une ouverture pour l'introduction du composant dirigée vers celui-ci, et qui forme une cavité comportant, du côté de l'introduction du composant, une ouverture conformée pour guider le composant dans le boîtier, la fermeture des mors permettant le maintien du boîtier lors de l'introduction du composant et l'ouverture des mors permettant l'avance de la bande et/ou du support mobile.

L'idée mère de l'invention est ici constituée par le fait que l'on place une pièce intermédiaire sous forme d'entonnoir entre le composant et le boîtier, les parois latérales de l'entonnoir permettant de guider le composant jusque dans le boîtier, même si l'alignement du boîtier et du composant n'est pas correct au départ. Le boîtier peut être ainsi amené par tous moyens entre les mors de la pince. Dans ce but, le boîtier peut être par exemple amené par translation horizontale entre les mors ouverts, ceux-ci se refermant sur le boîtier avant l'introduction du composant. De préférence, les mors possèderont également une seconde ouverture permettant l'introduction du boîtier selon le même procédé de guidage que pour le composant. Ces ouvertures dans les mors permettant d'une part l'introduction du composant et d'autre part l'introduction du boîtier seront de préférence disposés sur deux faces opposées de la pince. La forme «d'entonnoir» donnée à chacune des ouvertures sera réalisée par des chanfreins d'entrée desdites ouvertures.

Selon un autre aspect de l'invention, les boîtiers seront logés dans un plateau mobile, chaque boîtier étant successivement amené au droit d'un composant à encapsuler, le boîtier étant extrait de son logement et poussé autour de la pince à l'aide d'un piston qui est maintenu sous le boîtier pendant l'introduction du composant puis retiré lorsque l'encapsulation est terminée, l'ouverture des mors de la pince permettant alors l'avance d'un pas de la bande et du plateau mobile pour une nouvelle encapsulation.

L'invention sera mieux comprise à l'aide des exemples de réalisation suivants, donnés à titre non limitatif, conjointement avec les figures qui représentent:

la fig. 1, une vue d'ensemble d'une chaîne pour la mise en boîtier de composants électroniques, selon l'invention,

la fig. 2, une vue schématique du dispositif selon l'invention dans lequel les mors de la pince sont ouverts,

la fig. 3, une vue identique à celle de la fig. 2, dans laquelle les mors de la pince sont fermés,

les figg. 4 à 6, une vue en coupe des différentes étapes d'encapsulation du composant,

la fig. 7, une vue en coupe d'un composant après encapsulation dans un boîtier à l'aide d'un dispositif selon l'invention.

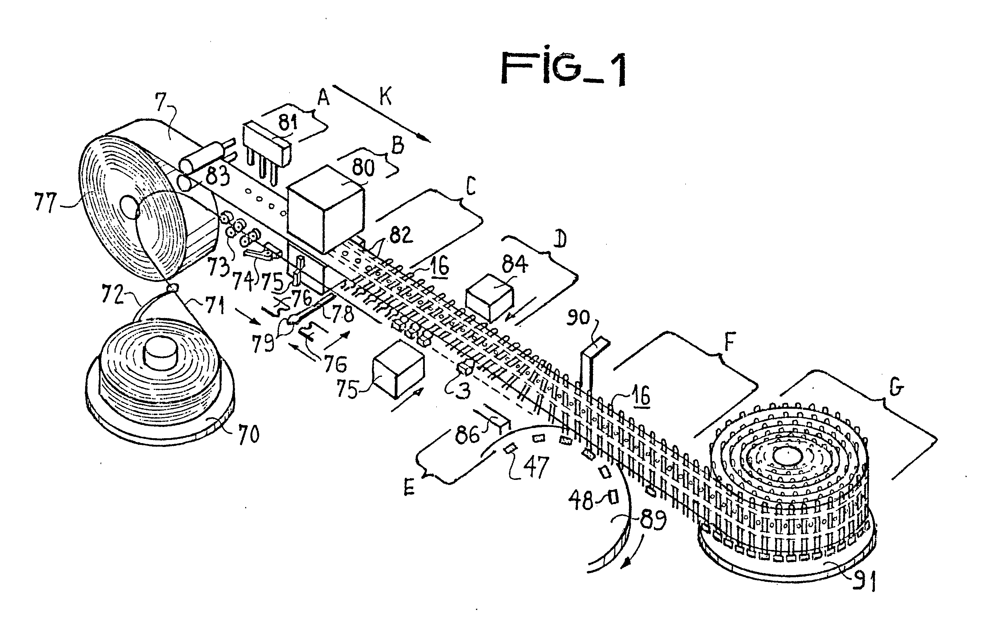

Sur la fig. 1, est représenté schématiquement un exemple de réalisation d'une ligne de fabrication de composant électronique selon le procédé de l'invention. Une bande de carton 7 de largeur appropriée est déroulée de la bobine 77 puis perforée à l'aide de la station de perforation A de manière à réaliser les perforations 4 pour l'avance régulière de la bande. Celle-ci passe ensuite dans la station de perforation B qui découpe les encoches appropriées pour placer ensuite des connexions en forme d'épingle. Il est à noter que ces deux étapes du procédé sont généralement réalisées avant le début de celle-ci, la bande étant livrée entièrement perforée par le fabricant. On réalise ensuite sur place les épingles de connexion selon la forme voulue au cours de l'étape C du procédé. Pour cela, une bobine 70 de fil 71 est dévidée et guidée à travers les guides 72, 73 et 74. Le fil est ensuite guidé à l'aide de l'outil 78 au travers des fentes telles que 82 de la bande perforée. Le fil 71 prend alors la forme de l'outil 78 muni de deux parties convexes 79. Ce fil est plaqué contre l'outil 78 à l'aide de la presse 76 ce qui permet la réalisation des épingles 16 après découpe du fil à l'aide de l'outil de coupe 75. La bande 7 avance pas à pas à l'aide des perforations telles que 83. Les connexions en forme d'épingle 16 étant ainsi formées et mise en place sur la bande perforée 7, elles se déplacent ensuite pour l'étape D du procédé en direction de la station 84, 85 de soudure du composant 3 à ladite connexion en forme d'épingle 16. Les pinces 16 et la bande jusqu'alors horizontale, subissent ensuite une rotation de 90° de manière à amener lesdites épingles et le composant soudé à son extrémité dans un plan vertical, le composant se trouvant vers le bas de la bande 7. Simultanément, une table tournante 89 munie d'alvéoles 48 se déplace en regard desdits composants. Les alvéoles 48 avant leur passage sous les composants sont munies d'un boîtier 47 rempli de résine liquide par la station 86. Lorsq'un composant se trouve au-dessus du boîtier 47 rempli de résine liquide, la bras 90 abaisse celui-ci par l'intermédiaire de l'épingle 16 et le composant vient se loger dans le boîtier. Le bras 90 est alors relevé pour amener à nouveau l'épingle 16 au même niveau que les autres épingles, celle-ci ayant maintenant un boîtier à son extrémité. La bande 7 ainsi que la table pivotante 89 avancent alors d'un pas et le procédé recommence. Cette étape d'insertion du composant dans le boîtier est l'étape F du procédé. Le composant alors muni de son boîtier est enroulé au cours de l'étape G du procédé sur un mandrin 91. Sur la fig. 1, le sens d'avance de la bande 7 et des composants est représenté par la flèche K.

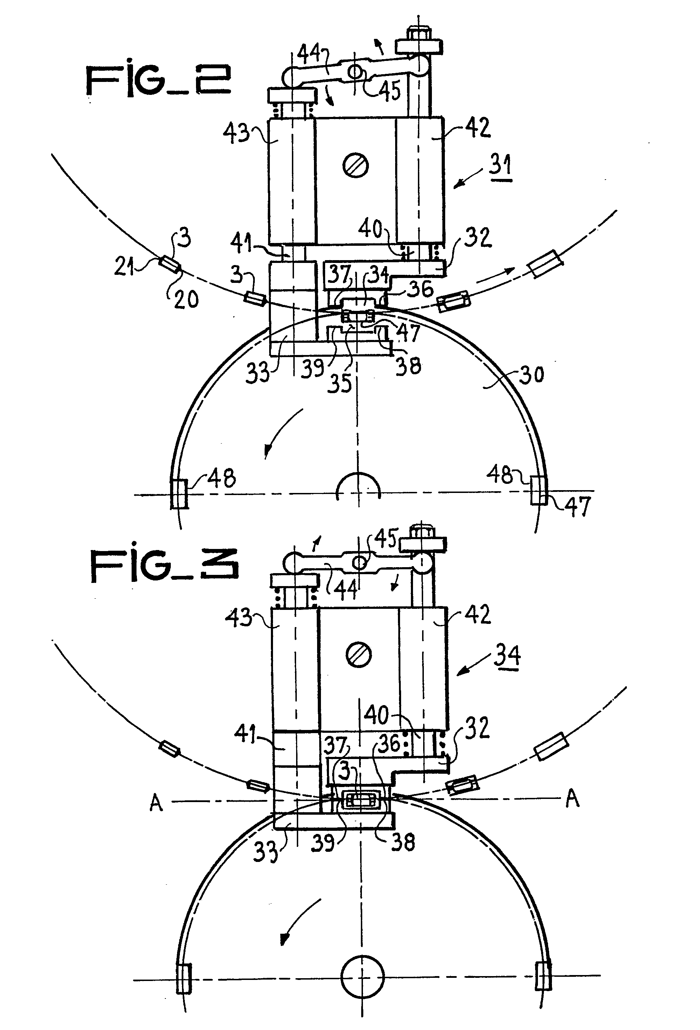

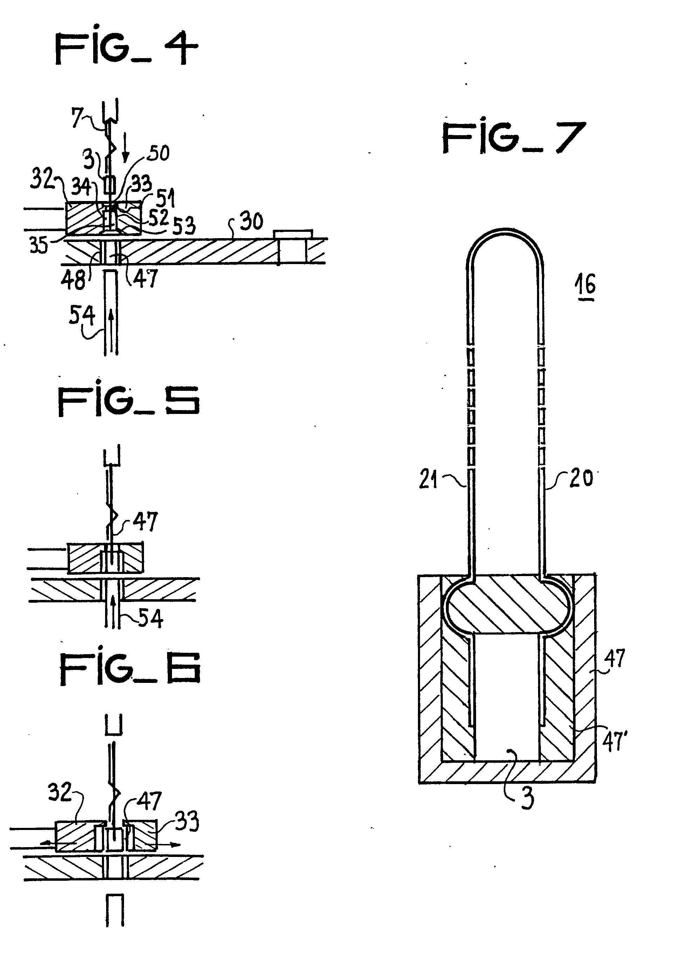

Sur la fig. 2, est représentée une vue de dessus schématique du dispositif de mise en boîtier selon l'invention et correspondant à l'étape F du procédé de la fig. 1. La bande 7 de condensateurs 3 suit sur cette figure une trajectoire sensiblement circulaire. Cette bande 7 est avancée pas à pas à l'aide des perforations 43 représentées sur la fig. 1. Lorsqu'un condensateur 3 est mis dans un boîtier 47, un autre condensateur est amené en position d'encapsulation ainsi qu'on le verra par la suite. Les boîtiers 47 sont, quant à eux, logés dans des alvéoles 48 disposées sur un plateau tournant 30. Ce plateau est muni de quatre alvéoles 48 disposées à sa périphérie, à 90° les unes des autres. Dans cet exemple, le plateau 30 est animé d'un mouvement de rotation en sens inverse de celui de la bande 7. Le dispositif caractéristique de l'invention est représenté dans son ensemble par le repère 31. Il comporte essentiellement une pince constituée par deux mors 32 et 33. Chacun de ces mors possède une empreinte intérieure 34 et 35 identique dans cet exemple, et ayant la forme d'un demi-boîtier 47 vu en coupe horizontale. Ces empreintes 34, 35 sont donc dans le cas présent des demi-rectangles (vu en coupe horizontale). Les extrémités planes 36, 37 du mors 32 sont en regard des extrémités 38, 39 du mors 33. Ces extrémités sont destinées è coopérer respectivement deux à deux ainsi qu'on le verra sur la fig. 3, l'extrémité 37 venant s'appuyer sur l'extrémité 39 tandis que l'extrémité 36 vient s'appuyer sur l'extrémité 38. Chacun des mors 32, 33 est relié à un bras 40, 41 permettant son déplacement dans le sens vertical sur la figure, par coulissement dans une chemise 42, 43. Chacun de ces bras est entrainé dans un mouvement par un palonnier 44 unique, animé d'un mouvement de rotation autour de l'axe 45. Sur la fig. 2, les mors 32 et 33 de la pince sont ouverts, le palonnier ayant été entraîné en rotation dans le sens des flèches indiqué sur cette figure. Dans cette position des mors 32 et 33, un condensateur 3 muni de ces connexions latérales 20 et 21 et fixé sur la bande 7 peut donc être amené sans difficulté entre ceux-ci, sensiblement au-dessus d'un boîtier 47. La suite des opérations de mise un boîtier est représentée sur la fig. 3, figure sur laquelle les mêmes éléments que ceux de la fig. 2 portent les mêmes références. Sur cette figure, le mouvement du palonnier 44 autour de son axe de rotation 45 dans le sens des flèches indiqué sur la figure a permis le rapprochement des mors 32 et 33 par coulissement des bras 40 et 41 dans les chemises 42 et 43. Le mouvement s'arrête lorsque les surfaces 36 et 38 d'une part, 34 et 39 d'autre part, viennent en butée l'une contre l'autre. A cet instant, un condensateur 3 est disposé au-dessus de l'empreinte réalisée par les surfaces internes des mors 34 et 35. Par ailleurs, un boîtier 47 est disposé sous lesdits mors 32 et 33 et l'opération de mise en boîtier est prête à commencer. Cette opération proprement dite va maintenant être décrite à l'aide des figures 4 à 6 qui représentent schématiquement une coupe selon l'axe AA de la fig. 3 montrant les étapes successives de la mise en boîtier. Sur ces figures, les mêmes éléments que ceux des figures précédentes portent les mêmes références. Sur la fig. 4, le plateau rotatif 30 est disposé de telle sorte qu'un boîtier 47 est placé en-dessous de la pince formée par les mors 32 et 33. Sur cette figure, on voit particulièrement bien la forme des empreintes 34 et 35 de ces mors. Ces empreintes, identiques, forment ensemble une cavité qui, verticalement et de haut en bas, comporte successivement un chanfrein d'entrée 50 pour le composant 3, puis une partie parallélépipédique 51, ayant une forme rectangulaire vue en coupe verticale sur la fig. 4, cette partie 51 ayant une largeur sensiblement égale à la largeur du composant 3 à introduire. La cavité formée par le mors 32 et 33 se prolonge ensuite par une partie parallélépipédique de forme sensiblement identique à la forme d'un boîtier 47, cette partie parallélépipédique 52 se prolongeant vers le bas par un chanfrein d'entrée 53 du boîtier 47. Le plateau 30 est perforé de part en part au niveau du logement 48 pour le boîtier 47. Un piston 54 disposé sous le plateau 30 permet par un mouvement de transition verticale dirigé vers le haut d'introduire le boîtier 47 entre les mors 32 et 33 de la pince, dans le logement 52 de taille sensiblement identique à celle du boîtier 47. Cette introduction est bien entendu facilitée par le chanfrein d'entrée 53 qui permet le guidage du boîtier entre les mors dans le cas où la cavité 52 et le boîtier 47 ne seraient parfaitement alignés. Après cette opération d'introduction du boîtier entre les mors, le condensateur 3 sur sa bande 7 est à son tour introduit entre les mors 32 et 33 de la pince, dans le sens vertical dirigé vers le bas de la figure. Le condensateur 3 est guidé par le chanfrein d'entrée 50 disposé sur les faces supérieures des mors, puis centré par rapport au boîtier 47 logé dans la cavité 52, à l'aide de la cavité parallélépipédique 51 de largeur identique à celle du condensateur 3. Après ces deux opérations d'introduction du boîtier entre les mors et du composant dans le boîtier à l'aide de la pince, on se retrouve alors à l'étape représentée sur la fig. 5. Au cours de cette étape, ainsi que cela est illustré sur cette figure, le piston 54 est maintenu sous le boîtier 47 de manière à le maintenir en position au cours de l'introduction du condensateur 3.

Sur la fig. 6, les mors 32 et 33 de la pince se sont à nouveau écartés ce qui permet la translation de la bande support et l'arrivée d'un nouveau condensateur au-dessus du boîtier, amené pendant le déplacement de la bande.

Comme représenté sur la fig. 7, le résultat des opérations ci-dessus est un condensateur 3 maintenu par de la résine 47' à l'interieur d'un boîtier 47.

## Revendications

1. Dispositif pour la mise en boîtier de coposants électroniques sur bande comportant, des moyens d'avance pas à pas d'une bande (7) sur laquelle sont disposées les connexions électriques des composants placées à une extrémité de celle-ci, des moyens d'avance pas à pas d'un support mobile (89) portant des boîtiers, ainsi que des moyens (90) de translation du composant sur la bande de manière à amener ledit composant dans un des boîtiers, caractérisé en ce qu'il comporte en outre une pince constituée de deux mors (32, 33) qui, au contact l'un de l'autre, possèdent une empreinte intérieure (34, 35) qui a sensiblement la dimension extérieure du boîtier, celui-ci possédant au moins une ouverture pour l'introduction du composant dirigée vers celui-ci, et qui forme une cavité comportant, du côté de l'introduction du composant, une ouverture (50) conformée pour guider le composant dans le boîtier, la fermeture des mors permettant le maintien de boîtier lors de l'introduction du composant et l'ouverture des mors permettant l'avance de la bande et/ou du support mobile.

2. Dispositif pour la mise en boîtier de composants électroniques selon la revendication 1, caractérisé en ce que l'empreinte intérieure (34, 35) des deux mors est identique.

3. Dispositif selon l'une des revendications 1 ou 2, caractérisé en ce que les mors comportent, sur la face correspondant à l'introduction du boîtier, une ouverture (53) conformée pour faciliter cette introduction.

4. Dispositif selon l'une des revendications 1 à 3, caractérisé en ce que la cavité formée par l'empreinte intérieure des deux mors comporte, selon le sens d'introduction du composant, une ouverture (50) constitué par un chanfrein d'entrée du composant (3), une partie parallélépipédique (51) conformée pour recevoir le composant (3) à introduire, une partie parallélépipédique (52) conformée pour recevoir le boîtier (47) et une ouverture (53) constituée par un chanfrein d'entrée pour le boîtier.

5. Dispositif selon l'une des revendications 1 à 4, caractérisé en ce que les deux mors sont commandés par un palonnier (44) unique, qui par un mouvement de rotation, leur transfert un mouvement en sens inverse.

6. Dispositif selon l'une des revendications 1 à 5, caractérisé en ce que le support mobile des boîtiers est constitué par un plateau circulaire (30) muni d'alvéoles (48) dans lesquels sont disposés lesdites boîtiers (47).

7. Dispositif selon la revendication 6, caractérisé en ce que des moyens de translation (54) des boîtiers sont prévus pour permettre l'introduction du boîtier entre les mors.

8. Dispositif selon la revendication 7, caractérisé en ce que les moyens de translation sont constitués par un piston (54) disposé sous le plateau mobile (30) percé d'une ouverture correspondante.

9. Dispositif selon la revendication 8, caractérisé en ce que le piston (54) soutient le boîtier pendant l'introduction du composant.

10. Dispositif selon l'une des revendications 1 à 9, caractérisé en ce qu'il comporte également des moyens (86) d'introduction de résine liquide durcissable dans les boîtiers avant mise en position dans les mors.

11. Procédé pour la mise en boîtier de composants électroniques utilisant le dispositif de la revendication 1, dans lequel le composant (3) est introduit dans un boîtier (47) comportant une face ouverte dirigée vers ledit composant, caractérisé en ce que ledit boîtier est maintenu en position fixe au cours de l'introduction du composant par une pince (31) dont les mors (32, 33) se resserrent autour du boîtier, ledit composant étant guidé dans le boîtier par le chanfrein (50) de l'ouverture pratiquée dans une première face des mors orientée vers le composant.

12. Procédé selon la revendication 11, caractérisé en ce que l'on introduit tout d'abord le boîtier (47) entre les mors par une ouverture (53) située sur une seconde face, opposée à la première, et munie de chanfrein, la face ouverte du boîtier étant dirigée sensiblement parallèlement à la première face.

13. Procédé selon la revendication 12, caractérisé en ce que l'introduction du boîtier est réalisée à l'aide d'un piston (54) qui pousse le boîtier entre les mors (32, 31).

14. Procédé selon la revendication 13, caractérisé en ce que le piston (54) est maintenu sous le boîtier (47) pendant l'introduction du composant.

15. Procédé selon l'une des revendications 11 à 14, caractérisé en ce que après introduction du composant dans le boîtier, les mors (32, 31) sont ouverts et permettent l'avance de l'ensemble composant et boîtier, lesdits mors se refermant ensuite à nouveau en vue d'une nouvelle opération d'introduction du boîtier et du composant.

## Patentansprüche

1. Vorrichtung zum Einbau von auf einem Band aufgereihten elektronischen Bauteilen in ein Gehäuse, mit Mitteln, die ein Band (7) schrittweise vorrücken lassen, auf dem die an einem Ende jedes Bauteils liegenden elektrischen Anschlussdrähte der Bauteile angeordnet sind, mit Mitteln, die einen beweglichen Träger (89) für Gehäuse schrittweise vorrücken lassen, und mit Mitteln (90) zur Verschiebung des Bauteils auf dem Band derart, dass das Bauteil in eines der Gehäuse gelangt, dadurch gekennzeichnet, dass sie ausserdem eine aus zwei Backen (32, 33) gebilde-

7 **0 083 537** 8

te Zange aufweist, die im geschlossenen Zustand einen Hohlraum (34, 35) umschliessen, dessen Abmessungen im wesentlichen den Aussenmassen des Gehäuses entsprechen, wobei das Gehäuse mindestens eine Öffnung zum Einbringen des diesem zugewandten Bauteils besitzt und wobei die Zangenbacken eine Höhlung bilden, die auf der Seite der Einführung des Bauteils eine Öffnung (50) besitzt, die so gestaltet ist, dass das Bauteil in das Gehäuse hineingeführt wird, und dass das Schliessen der Backen es ermöglicht, das Gehäuse während der Einführung des Bauteils festzuhalten, wogegen das Öffnen der Backen das Vorrücken des Bandes und/oder des beweglichen Trägers erlaubt.

2. Vorrichtung zum Einbau von elektronischen Bauteilen in ein Gehäuse nach Anspruch 1, dadurch gekennzeichnet, dass der Hohlraum (34, 35) von beiden Backen in gleicher Weise umgeben wird.

3. Vorrichtung nach einem der Ansprüche 1 oder 2, dadurch gekennzeichnet, dass die Backen auf der der Einführung des Gehäuses entsprechenden Seite eine Öffnung (53) aufweisen, die so gestaltet ist, dass diese Einführung erleichtert wird.

4. Vorrichtung nach einem der Ansprüche 1 bis 3, dadurch gekennzeichnet, dass der von den beiden Backen umschlossene Hohlraum in Richtung der Einführung des Bauteils eine durch eine Eingangsabschrägung für das Bauteil (3) gebildete Öffnung (50), einen parallelepipedischen Teil (51) zur Aufnahme des einzuführenden Bauteils (3), einen parallelepipedischen Bereich (52) zur Aufnahme des Gehäuses (47) und eine Öffnung (53) besitzt, die durch eine Eingangsabschrägung für das Gehäuse gebildet wird.

5. Vorrichtung nach einem der Ansprüche 1 bis 4, dadurch gekennzeichnet, dass die zwei Backen von einem gemeinsamen Schwinghebel (44) gesteuert werden, der den Backen durch eine Schwenkbewegung eine gegenläufige Bewegung aufprägt.

6. Vorrichtung nach einem der Ansprüche 1 bis 5, dadurch gekennzeichnet, dass der bewegliche Träger für die Gehäuse von einer ringförmigen Platte (30) mit Vertiefungen (48) gebildet wird, in denen die Ghäuse (47) liegen.

7. Vorrichtung nach Anspruch 6, dadurch gekennzeichnet, dass Mittel zur Verschiebung (54) der Gehäuse vorgesehen sind, um die Einführung des Gehäuses zwischen die Backen zu ermöglichen.

8. Vorrichtung nach Anspruch 7, dadurch gekennzeichnet, dass die Mittel zur Verschiebung von einem Kolben (54) gebildet werden, der unter der mit einer entsprechenden Öffnung versehenen beweglichen Platte (30) angeordnet ist.

9. Vorrichtung nach Anspruch 8, dadurch gekennzeichnet, dass der Kolben (54) das Gehäuse während der Einführung des Bauteils unterstützt.

10. Vorrichtung nach einem der Ansprüche 1 bis 9, dadurch gekennzeichnet, dass sie auch Mittel (86) zur Einführung eines härtbaren flüssigen Harzes in das Gehäuse vor dem Instellungbringen der Backen enthält.

11. Verfahren zum Einbau elektronischer Bauteile in Gehäuse unter Verwendung der Vorrichtung gemäss Anspruch 1, wobei das Bauteil (3) in ein Gehäuse (47) mit einer zum Bauteil hin offenen Seite eingeführt wird, dadurch gekennzeichnet, dass das Gehäuse in einer festen Stellung während der Einführung des Bauteils durch eine Zange (31) gehalten wird, deren Backen (32, 33) sich um das Gehäuse schliessen, und dass das Bauteil im Gehäuse durch die Abschrägung (50) der Öffnung geführt wird, die an einer ersten, dem Bauteil zugewandten Seite der Backen vorgesehen ist.

12. Verfahren nach Anspruch 11, dadurch gekennzeichnet, dass zuerst das Gehäuse (47) zwischen die Backen durch eine Öffnung (53) eingebracht wird, die sich auf einer der ersten Seite gegenüberliegenden zweiten Seite befindet und die mit einer Abschrägung versehen ist, und dass die offene Seite des Gehäuses im wesentlichen parallel zur ersten Seite ausgerichtet ist.

13. Verfahren nach Anspruch 12, dadurch gekennzeichnet, dass die Einführung des Gehäuses mit Hilfe eines Kolbens (54) erfolgt, der das Gehäuse zwischen die Backen (32, 33) drückt.

14. Verfahren nach Anspruch 13, dadurch gekennzeichnet, dass der Kolben (54) unter dem Gehäuse (47) während der Einführung des Bauteils festgehalten wird.

15. Verfahren nach einem der Ansprüche 11 bis 14, dadurch gekennzeichnet, dass nach der Einführung des Bauteils in das Gehäuse die Backen (32, 33) geöffnet werden und den Vorschub der aus Bauteil und Gehäuse gebildeten Einheit ermöglichen, wobei die Backen sich dann erneut schliessen zu einer neuen Einbauphase für das Bauteil in das Gehäuse.

**Claims**

1. A device for placing electronic components, located on a belt, in cases comprising means for the stepwise advance of a belt (7), on which are arranged electrical connections of the components placed at one end thereof, means for the stepwise advance of a moving support (89) carrying cases, as well as means (90) for transferring the component on the belt in order to bring said component into one of the cases, characterized in that it further comprises a clamp consisting of two jaws (32, 33) which, in contact with one another, have an internal impression (34, 35) essentially representing the external size of the case, said case having at least one opening directed towards the component for receiving the latter, the case forming a cavity comprising an opening (50) for guiding the component into the case, the closing of the jaws leading to securing of the case during the introduction of the component, whilst the opening of the jaws makes it possible for the belt and/or the moving support to advance.

2. A device for placing electronic components in cases according to claim 1, characterized in that the internal impression (34, 35) of the two jaws is identical.

3. A device according to one of claims 1 or 2, characterized in that the jaws comprise an opening (53) on the corresponding to the introduction of the case, the shape of this opening being chosen to facilitate this introduction.

4. A device according to one of claims 1 to 3, characterized in that the cavity built by the inner impression of the two jaws comprises, along the direc-

5

tion of introduction of the components, an opening (50) consisting of an input chamfer of the component (3), a parallelepipedic portion (51) having a shape for receiving the component (3) which is to be introduced, a parallelepipedic portion (52) having a shape to receive the casing (47) and an opening (53) consisting of an input chamfer for the case.

5. A device according to one of claims 1 to 4, characterized in that the two jaws are controlled by a single rocking lever (4) which transfers thereto a movement in opposite direction by a rotational movement.

6. A device according to one of claims 1 to 5, characterized in that the moving support of the casing is constituted by a circular table (30) provided with recesses (48) in which are located said cases (47).

7. A device according to claim 6, characterized in that translation means (54) for the cases are provided to permit the introduction of the case between the jaws.

8. A device according to claim 7, characterized in that the translation means are constituted by a piston (54) disposed beneath the moving table (30) which is provided with a corresponding opening.

9. A device according to claim 8, characterized in that the piston (54) supports the case during the introduction of the component.

10. A device according to one of claims 1 to 9, characterized in that it further comprises means (86) for introducing hardenable liquid resin into the cases prior to their positioning in the jaws.

11. A method for placing electronic components in cases using the device of claim 1, in which the component (3) is introduced in the case (47) having an open face directed towards said component, characterized in that said case is maintained in a fixed position during the introduction of the component by a clamp (31), the jaws (32, 33) of which are tightened around the case, said component being guided in the case by the chamfer (50) of the opening made in a first face of the jaws directed towards the component.

12. A method according to claim 11, characterized in that the case (47) is firstly introduced between the jaws through an opening (53) situated on a second face opposite to the first one and provided with a chamfer, the open face of the case being directed substantially parallel to the first face.

13. A method according to claim 12, characterized in that the introduction of the case is obtained by means of a piston (54) which pushes the case between the jaws (32, 33).

14. A method according to claim 13, characterized in that the piston (54) is maintained between the case (47) during the introduction of the component.

15. A method according to one of claims 11 to 14, characterized in that following the introduction of the component into the case, the jaws (32, 33) are opened and permit the advance of the assembly composed of component and case, said jaws then closing again for the purpose of a further operation of introduction of a further component into a case.

# FIG_1

0 083 537

FIG_2

FIG_3

# FIG_4

# FIG_7

# FIG_5

# FIG_6